Europäisches Patentamt

(19) European Patent Office

Office européen des brevets

(11) Publication number: **0 110 997**
**B1**

(12) **EUROPEAN PATENT SPECIFICATION**

(45) Date of publication of patent specification: **01.02.89**

(51) Int. Cl.⁴: **H 01 L 23/12**

(21) Application number: **83901233.3**

(22) Date of filing: **26.04.83**

(86) International application number:
**PCT/JP83/00129**

(87) International publication number:
**WO 83/03922 10.11.83 Gazette 83/26**

(54) **SEMICONDUCTOR DEVICE PACKAGE.**

(30) Priority: **30.04.82 JP 73080/82**

(43) Date of publication of application:
**20.06.84 Bulletin 84/25**

(45) Publication of the grant of the patent:
**01.02.89 Bulletin 89/05**

(84) Designated Contracting States:
**DE FR GB**

(56) References cited:
**FR-A-2 244 264**
**JP-A-54 015 663**
**JP-A-56 091 449**

(73) Proprietor: **FUJITSU LIMITED**
**1015, Kamikodanaka Nakahara-ku**
**Kawasaki-shi Kanagawa 211 (JP)**

(72) Inventor: **Hidaka, Norio**
**3-21, Kyowa 3-chome Sagamihara-shi**
**Kanagawa 229 (JP)**
Inventor: **YAMAMURA, Shigeyuki**
**22-14, Kamiyabe 5-chome Sagamihara-shi**
**Kanagawa 229 (JP)**
Inventor: **FUKUTA, Masumi**
**14-1460, Shinkoji-machi**
**Machida-shi Tokyo 194 01 (JP)**

(74) Representative: **Muir, Ian R. et al**
**HASELTINE LAKE & CO. Hazlitt House 28**
**Southampton Buildings Chancery Lane**
**London WC2A 1AT (GB)**

Courier Press, Leamington Spa, England.

## Description

This invention relates to a semiconductor device package.

With the rapid progress of data processing systems in terms of operation speed and capacity, continuous efforts have been made towards the development of a semiconductor device to be applied to data processing to realize operation at higher frequency and higher electrical power.

For example, as an active semiconductor device, a semiconductor element consisting of compound semiconductor such as gallium-arsenide (GaAs), for example a gallium-arsenide Schottky barrier type field effect transistor, is being applied in place of existing semiconductor elements consisting of silicon (Si), and such gallium-arsenide Schottky barrier type field effect transistors are being further improved step by step so that they can now operate at higher frequency and provide higher electrical power.

For packages for accommodating such semiconductor devices operating at higher frequency and electrical power, structures as shown in Fig. 1 to Fig. 12 have been proposed.

Fig. 1 is a perspective view of a main part of a ceramic frame type package. 1 is a copper (Cu) base; 2 is a ceramic case; 2A is a first ceramic frame; 2B is a second ceramic frame; 3 is a lead segment; 4 is a metallized film for sealing, respectively.

Fig. 2 is a perspective view of a main part of a ceramic plate type package. 5 is a copper base; 6 is a ceramic plate; 6A is a window for accommodating a semiconductor element; 7 is a conductive film, respectively.

These packages are now widely used, because they are small in size and cheap, as packages for semiconductor elements or small-size solid state apparatuses. However, attempts now made for attaining higher performance have encountered various problems.

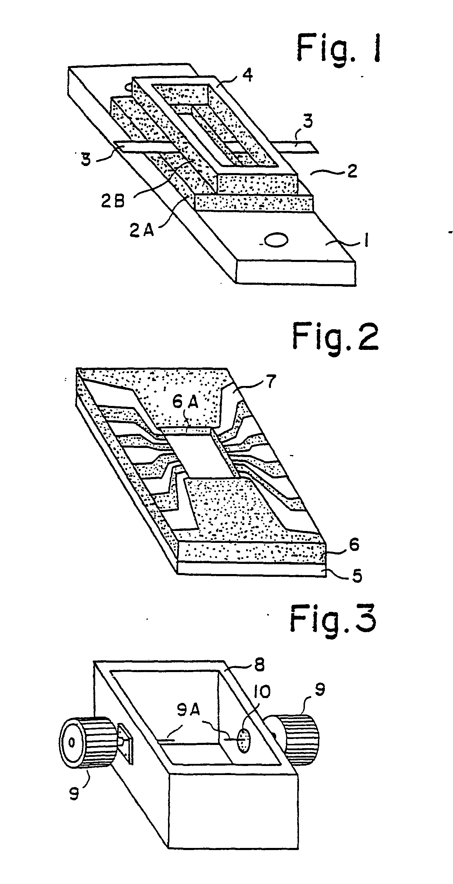

For example, in the case of the structure shown in Fig. 1, when an element is hermetically sealed by securing a ceramic cover on the metallized film 4, the ring-shaped metallized film 4 on the ceramic frame 2B may resonate. Such resonance occurs at a frequency determined in accordance with circumferential length of ring-shaped metallized film 4. In a case in which a metal cover, or a ceramic cover whose entire area is metallized, is used for sealing, the resonant frequency can be raised a little, but resonance occurs in accordance with the area metallized. Therefore, the structure is restricted to relatively low frequency use, and is generally not used in the ultra-high frequency region for this reason.

Moreover, a package having a structure such as is shown in Fig. 2 is unsuitable for ultra-high frequency use for a further reason: crosstalk may occur between the conductive films 7.

Actually this package was designed for high speed digital circuits. In recent years, digital circuits have also undergone urgent development, particularly to cope with requirements for high speed operation, and accordingly circuits operating in the GHz band are now appearing based on Si system as well as GaAs system elements. Such circuits, for example, logic circuits and memory circuits, have complicated functions and provide as input/output terminals as many as 10 to 40 pins.

Improvement in high speed operation of these logic and memory circuits is accompanied by other problems in addition to the sealing problem mentioned above, such as the crosstalk problem mentioned above; namely leakage of signals due to combinations of signals between terminals, because of existence of many terminals within a restricted area, resonance and oscillation and moreover high speed operation is deteriorated by increased parasitic capacitance at a sealing area.

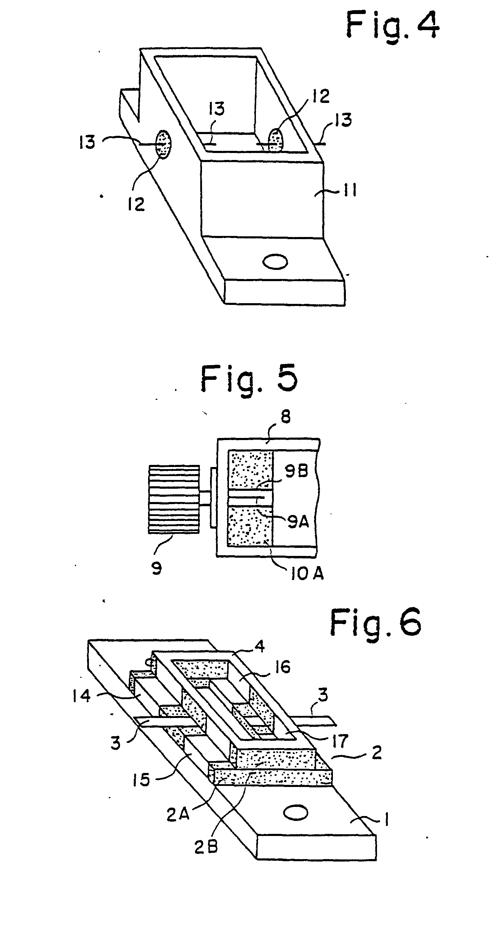

Thus, with a view to use in a ultra-high frequency band, circuits are currently formed on carriers manufactured by laminating copper and ceramic, and the carriers are placed within metal case type packages as shown in Fig. 3 or Fig. 4 and the entire structure is sealed in order to protect the circuits from ambient conditions.

Fig. 3 is a perspective view of a metal case type package. 8 is a metal case; 9 is a coaxial connector; 9A is a core conductor; 10 is an insulator consisting of ceramic or resin, respectively.

Fig. 4 is a perspective view of a metal case type package with brims; 11 is a metal case with brims; 12 is an insulator; 13 is a core conductor, respectively.

These packages suffer a disadvantage in that they are of increased size and have further disadvantages as explained in detail below.

Namely, in the example of Fig. 3, the coaxial line is provided at the sealing part, connection with an external circuit is effected through the coaxial connector 9 and connection with internal circuits is effected through the extended core conductor 9A. Therefore, as shown in Fig. 5, a chip providing a strip line 9B of 50 [$\Omega$] impedance on a ceramic plate 10A is inserted into the package, core conductor 9A and line 9B are connected as a converting connection and line 9B and a pad of the internal circuits are lead-bonded to establish connection with the internal circuits using a strip line structure.

The structure of Fig. 3 provides a merit in that the coaxial connector 9 can easily be coupled to the coaxial connector of an external circuit but also has many demerits in terms of potential for realizing small size, high reliability and low cost, which features are all required currently for semiconductor devices, and particularly suffers the following two serious problems:-

(i) It is difficult to realize size reduction because a coaxial connector is used. With a view to solving this problem, the core conductor 13 can be connected to the strip line of an external circuit as shown in Fig. 4. This structure certainly provides a merit in that the coaxial connector can also be used as required, but it is difficult to guarantee the characteristics of the coaxial/strip line conversion since the conversion to strip line is all shared to users, and it is further difficult to realize impedance matched conversion circuits for a wider frequency band.

(ii) Hermetic sealing is difficult because sealing length is longer. Generally, when brazing is used, a brazing material is placed on the sealing area, the cover is then placed thereon, they are held with required force and then they are put into a thermostatic oven. The brazing material melts when it reaches its melting point and penetrates into the sealing area and metal of the cover, thus resulting in hermetic sealing. However, in this case, a large amount of gas within the package, for example nitrogen, is heated and expands, applying pressure from the inside of the brazing material to the outside. This causes pin-holes at the sealing area. Moreover, in a case in which a package is hermetically sealed by welding, it is difficult to keep welding conditions constant and welding must be carried out individually for each package, requiring increased time. Accordingly, yield is deteriorated, and manufacturing cost rises. Particularly welding becomes more difficult as the package becomes smaller.

On the other hand, the inventors of the present invention have attempted a modification, for example, as shown in Fig. 6, to the package of Fig. 1. In Fig. 6, the same portions as those in Fig. 1 are given the same reference symbols.

Namely, metallized films 14, 15, 16, 17 are formed on both inside and outside of the ceramic case 2, on both sides of lead segments 3, and moreover these films are in contact with the metallized film 4 and the effective length of ring consisting of metallized film 4 is curtailed. However, even such a modified package could not be used sufficiently in the high frequency range because of parasitic capacitance and parasitic inductance effects due to the metallized film.

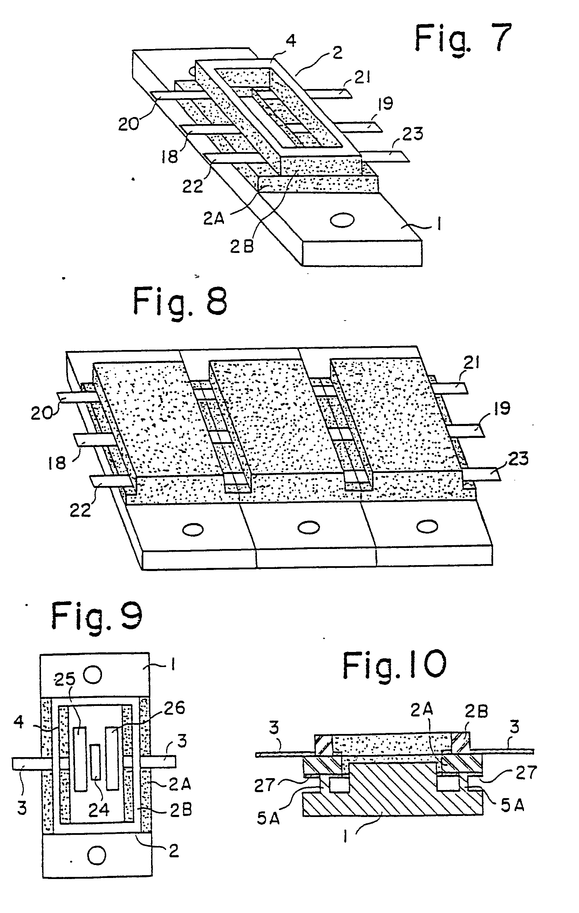

In addition, the inventors of the present invention have also manufactured an ultra-miniature package as shown in Fig. 7. In Fig. 7, the portions the same as those in Fig. 1 are given the same reference symbols.

This prior art is different from that of Fig. 1 in that it provides high frequency input terminal 18, high frequency output terminal 19 and DC input terminals 20, 21, 22, 23. Moreover, a balanced type amplifier forming ultra-miniature circuits on a sapphire substrate is contained within the package, although it is not shown. This device has a merit in that it is small in size and is hermetically sealed, and since the RF input and output terminals of the circuit on the sapphire substrate are matched to the characteristic impedance by using hybrid couplers formed on the sapphire substrate, it is also possible to directly connect a plurality of amplifier stages hermetically sealed by housing the circuits in the packages as shown in Fig. 8 and lead-bonding the terminals on the ceramic frame 2A within the package to the external connecting terminals of the circuits on the sapphire substrate.

In Fig. 8, three semiconductor devices sealed in packages as shown in Fig. 7 are directly connected and the portions the same as those in Fig. 7 are given the same reference symbols.

In Fig. 8, when high frequency input power is applied to the terminal 18 and DC voltages to the terminals 20, 22, respectively, these are then further supplied to the second and third stages and thereby a high frequency output can be obtained from the terminal 19. In regard to this device, it provides good performance in the 4 to 8 [GHz] range. When forming an amplifier for the 8 to 18 [GHz] range, a ring-shaped metallized film provided for hermetical sealing resonates, even if it receives the same treatment as is performed in the case of the package shown in Fig. 6, and its resonant frequency is about 11 [GHz] which is within the range 8 to 18 [GHz]. For this reason, such an 8 to 18 [GHz] amplifier could not be realized. An earth electrode poses another problem which will be explained later.

Currently, an internal matching type GaAs field effect semiconductor device as shown in Fig. 9 has been manufactured. In Fig. 9, the portions the same as those in Fig. 1 are given the same reference symbols.

This device provides, within the package, a semiconductor chip 24, input matching circuit 25 and output matching circuit 26, and for example, the impedance matching is carried out within the package for users for whom it is difficult to form the circuit using a semiconductor GaAs-FET chip 24, and thereby it is required only for the users to prepare a simple external matching circuit in order to obtain the desired characteristic, and a DC bias circuit. Accordingly, the device as shown in Fig. 9 is widely used because the desired characteristic can be obtained easily.

However, this package has a disadvantage in that satisfactory performance cannot be obtained when frequency becomes high, because an impedance of a GaAs-FET becomes low and moreover parasitic capacitance, parasitic inductance and high frequency loss in the package increase. In addition, because of resonance of a ring-shaped metallized film as mentioned above, and an earth electrode problem as explained later, currently usable packages are limited to frequencies up to about 10 [GHz]. Therefore, a package which can be used for a frequency band exceeding 10 [GHz], where the above-mentioned problems become more serious, has long been desired. But some packages are currently used in the frequency range of 10 [GHz] or higher. Namely, a very small-size package is used for frequencies up to 12 [GHz] but it is restricted in application because of its small size and is used only for low noise GaAs-FETs.

Here, an earth electrode problem which is common to ceramic frame-type packages will be explained.

In general, a package used in a high frequency band has suffered a problem of cracking, generated at its ceramic part, due to difference of thermal expansion coefficients between ceramic and metal portions. A package as shown in Fig. 10 has been proposed in order to prevent such cracking. In Fig. 10, the portions the same as those in Fig. 1 are given the same reference symbols.

As will be understood from the Figure, a ring 5A is formed on the base 1 and the ceramic frame 2A is mounted thereon. 27 is a metallized film.

This structure has an excellent effect in terms of preventing cracking. But, at frequencies higher than 10 [GHz], inductance of ring 5A, which exists between the metallized film 27 which is the earth electrode of the ceramic frame 2A and the base 1, becomes larger. Therefore, the metallized film 27, which works as the earth electrode, loses function as the earth electrode and strip-line impedance deviates from the optimum value, deteriorating performance.

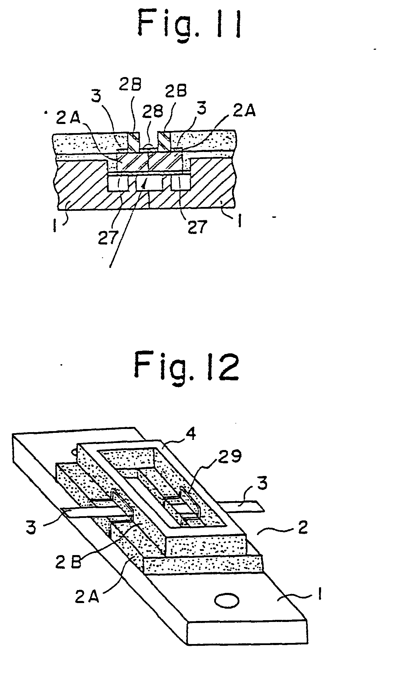

Moreover, when packages as shown in Fig. 10 are coupled as indicated in Fig. 11, there is a disadvantage that a cavity is formed at the area indicated by an arrow in Fig. 11 and thereby resonance at a frequency of about 8 [GHz] occurs. Devices can be cascaded by contacting packages to each other and bonding 28 lead segments 3 as shown in Fig. 11.

As an electrical terminal structure of a ceramic frame-type package, a structure as shown in Fig. 12 has been proposed by the inventors of the present invention. In Fig. 12, the portions the same as those in Fig. 1 are given the same reference symbols.

In Fig. 12, annular metal material parts 29, for example which are made of metallizing materials, are disposed on the ceramic case 2 arranged on the base 1 in such a way as to surround ceramic portions on which the lead segments 3 are extended from the walls of the ceramic case 2, and the annular metal material parts 29 are connected electrically to the base 1.

Such a structure exhibits a better characteristic for the frequency band 4 to 8 [GHz] since the electric terminal portion provides a pseudo coaxial cable configuration, with the annular metal material part 29 acting as earthing conductor.

However, for example, in the 8 to 18 [GHz] band, not only cannot desired performance be obtained because of parasitic capacitance between the annular metal material part 29 and metallized film 4 for sealing, but also the annular metal material part 29 is not perfectly earthed for a high frequency, for example, as high as 10 [GHz] or more and exhibits an inductance. In an extreme case, said annular metal material part functions as an antenna.

As will be clear, advent of packages which can be used for frequencies of 10 [GHz] or higher is desired for ultra-high frequency circuits and high speed digital circuits, and the situation is becoming serious day by day because recent packages employ the structure of strip line (connection with external circuit) - strip line (sealing part) - strip line (connection with internal circuit).

It is a primary object of the present invention to provide a semiconductor device package structure suitable for ultra-high frequency or high speed digital circuits.

It is another object of the present invention to provide a package structure which does not suffer cracking resulting from differences of thermal expansion coefficients between insulator and electric terminal portions.

It is still another object of the present invention to provide a package structure which does not allow generation of resonance or parasitic capacitance, etc., at the securing portion of cover for hermetic sealing.

According to the present invention, there is provided a semiconductor device package, comprising:-

a metal case with a through hole in its wall part, and a metal base;

a laminated electrical terminal located in the through hole;

the laminated electrical terminal comprising:-

an insulator base part having a planar surface;

a strip line conductor layer formed on the planar surface of the insulator base part; and

an insulator bridge part abutting the planar surface of the insulator base part, and the strip line conductor layer thereon, portions of the planar surface of the insulator base part, and the strip line conductor layer, being exposed on both sides of the insulator bridge part, the exposed portions extending to the inside and to the outside of the metal case.

BRIEF DESCRIPTION OF DRAWINGS

Fig. 1 to Fig. 12 illustrate structures of existing semiconductor devices. Fig. 1 to Fig. 4, Fig. 6 to Fig. 8, and Fig. 12 are perspective views of main portions. Fig. 5 and Fig. 9 are plan views of the main portions. Figs. 10, 11 and 12 are cross-sectional views of main portions.

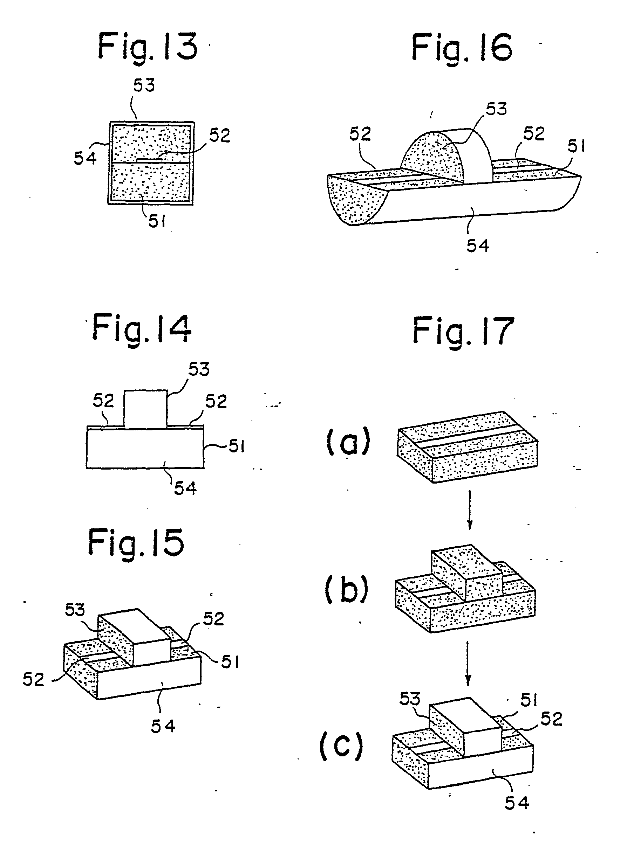

Fig. 13 to Fig. 15 are a plan view, a side view and a perspective view of the structure of an electric terminal to which the present invention is applied.

Fig 16 is a perspective view indicating another embodiment of an electric terminal, and Fig. 17 is a perspective view indicating the manufacturing process of the electric terminal, to which the present invention is applied.

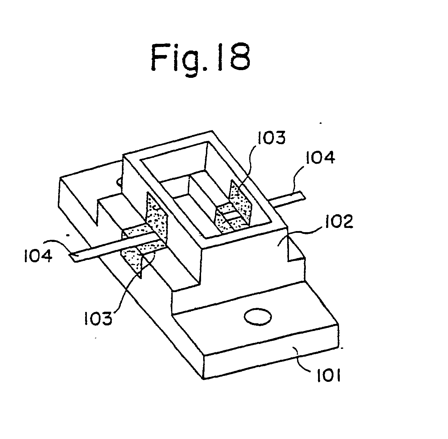

Fig. 18 is a perspective view of a main portion of an embodiment of a semiconductor device of the present invention.

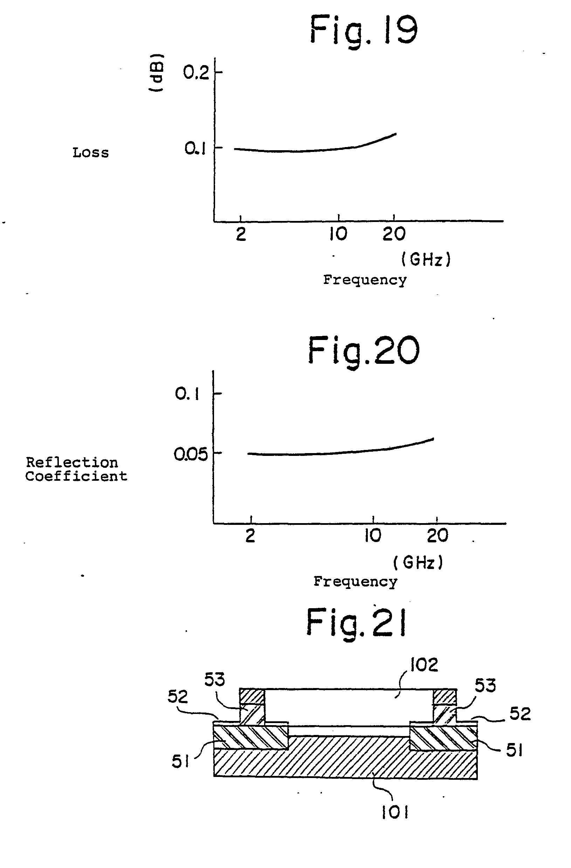

Fig. 19 and Fig. 20 are graphs indicating characteristics of the embodiment shown in Fig. 18.

Fig. 21 is a sectional view of the main portion of the embodiment shown in Fig. 18.

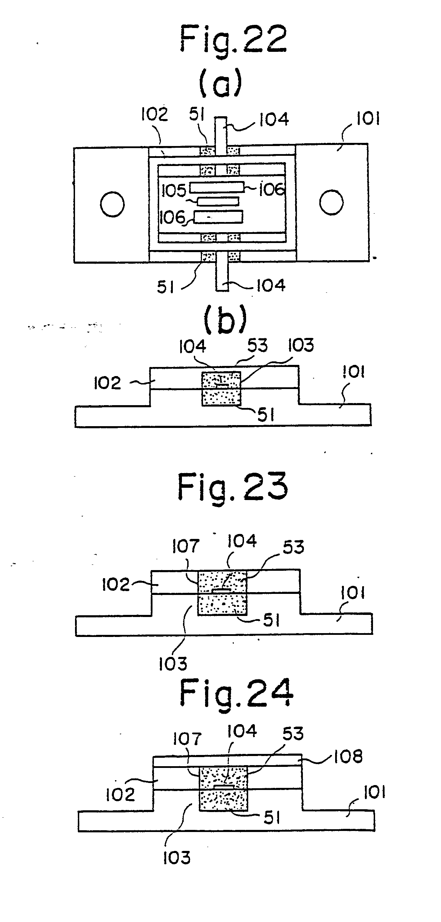

Fig. 22(a) is a plan view, while Fig. 22(b) is a front view of a main portion of another embodiment of the present invention.

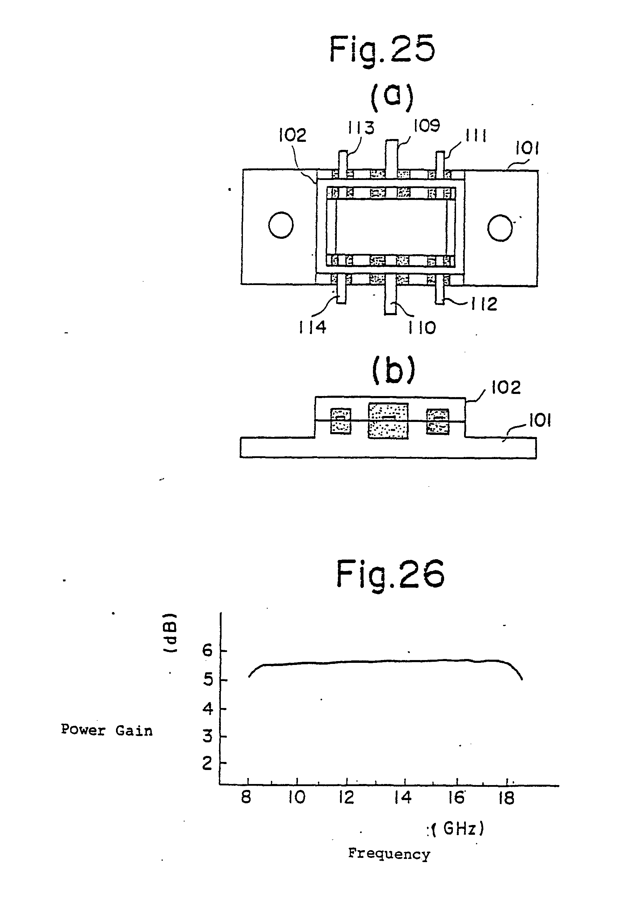

Fig. 23 and Fig. 24 are front views of the main portions of other embodiments of the present invention.

Fig. 25(a) is a plan view, while Fig. 25(b) is a front view of a main portion indicating another embodiment of the present invention.

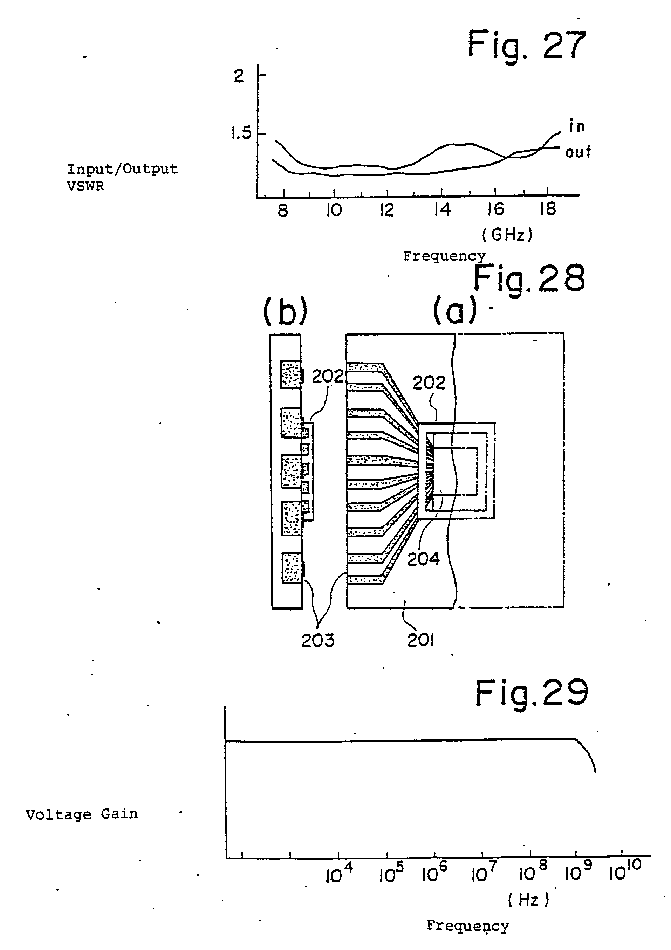

Fig. 26 and Fig. 27 are graphs indicating characteristics of the embodiment shown in Fig. 25.

Fig. 28(a) is a plan view, while Fig. 28(b) is a front view of a main portion of another embodiment of the present invention.

Fig. 29 is a graph indicating characteristic of a differential amplifier of the embodiment shown in Fig. 28.

The semiconductor device package in accordance with a first embodiment of the invention will now be described.

Fig. 13, Fig. 14 and Fig. 15 are respectively a front view, side view and perspective of an electric terminal used in a semiconductor device of the present invention.

In these Figures, 51 is an insulator base, for example, consisting of a ceramic plate; 52 is a strip line consisting of a conductive layer formed on the surface of base 51; 53 is an insulator bridge, for example, consisting of a ceramic plate; 54 is a metallized film, respectively. The bridge 53 is the same in width as the base 51 and is shorter than the base 51 in length (namely in the direction of the strip line 52). Therefore, the strip line 52 is partly exposed.

Fig. 16 is another embodiment of the electric terminal and the same portions as those of Fig. 15 are given the same reference symbols.

This embodiment is different from the first embodiment explained before only in that the base 51 and bridge 53 are respectively semicircular and they form a circle in combination when they are observed from the front end.

Fig. 17 is an example of the method of manufacturing an electric terminal to be used in the present invention.

As shown in Fig. 17(a), for example, a metal pattern (corresponding to the strip line 52) of laminate consisting of the tungsten (W) is formed on an alumina raw ceramic plate (corresponding to the base 51, unbaked ceramic substrate, generally called a green sheet), then as shown in (b), for example, a small size alumina raw ceramic plate (corresponding to the bridge 53) is placed thereon and baked, thereafter as shown in (c), metallized film is formed at the bottom surface, side surface and upper surface of the assembly, thus completing an element. After brazing the assembly on to a metal base, gold (Au) is plated on. The electric terminal of the present invention is not required to be always square or circular as shown in Fig. 15 or Fig. 16 when viewed from the front end, it may be polygonal or of other shape.

In this electrical terminal, one edge or end of strip line 52 is connected to an external circuit, while the other edge or end is connected to internal circuits, with separation by the bridge 53, respectively. Connection is carried out, for example, by lead bonding and an electrical characteristic obtained is similar to that of a coaxial line. The laminate part of strip line 52, namely the area defined by the base 51 and bridge 53 is generally ribbon-shaped and the external conductor (main body of the metal package) which combines in high frequency band through an insulator is usually square-shaped (though it can also be formed with circular cross-section) and therefore these cannot strictly be said to be coaxial, but can be considered to be a pseudo-coaxial line from the view point of electrical fields because the external conductor, which functions as earth electrode, is extended up to the side thereof.

The size of such structure of strip line - pseudo coaxial line - strip line can be freely designed. In an example of Fig. 13, a package forms, when observed from the front side, a square with a side of 1.2 [mm], length of bridge 53 (Fig. 14) in the same direction as the strip line of 0.5 [mm], length of the insulator base 51 supporting the bridge 53 in the same direction as the strip line of 1 [mm], length of strip line 52 of 0.25 [mm], width of the same of 0.3 [mm], laminate length of 0.5 [mm] and width of the same of 0.25 [mm].

Fig. 18 is a perspective view of the main portion of an embodiment of the present invention.

In the Figure, 101 is a metal base consisting of copper (Cu), 102 is a case thereof, 103 is an electric terminal engaged insertingly with a through hole provided in a wall part of said case 102, 104 is a lead segment connectingly secured to the strip line 52 of electric terminal 103.

Although not shown in the Figure, a semiconductor element and matching circuit, etc., accommodated within the case 102 are hermetically sealed by a metal or ceramic cover disposed covering the window of said case 102. The surface of a ceramic cover is metallized as required.

The characteristics of input/output terminals of this embodiment are shown in Figs. 19 and 20.

In Fig. 19, a high frequency loss is plotted on the vertical axis, while frequency is plotted on the horizontal axis. In Fig. 20, a power reflection coefficient at the terminal is plotted on the vertical axis, while frequency is plotted on the horizontal axis. Judging from these characteristic curves, this device can be used for an ultra-high frequency of 18 [GHz] and it can be expected that it can also be used in further, higher, frequency bands.

Such an excellent characteristic is ensured by the fact that said ring-shaped metallized film does not generate any resonance and the ring-shaped part 5A shown in Fig. 10 is not employed. This will then be explained with reference to Fig. 21.

Fig. 21 is a cross-sectional view in the vicinity of an electrode terminal of Fig. 18. The portions the same as those in Fig. 15 and Fig. 18 are also given the same reference symbols.

As is apparent from the Figure, this embodiment provides the structure that the insulator base 51 and bridge 53 are directly in contact with the earth electrode, namely in contact with the metal base 101 or case 102. Accordingly, it is ensured that the part corresponding to external conductor of the strip lines and the pseudo-coaxial line (in the vicinity of laminate of strip line) are reliably earthed, there is no discontinuousness in impedance because the connecting part to the external circuits is formed as the strip line, the strip line and pseudo-coaxial line are designed optimumly and the upper surface of metal case 102 forms the metal layer for hermetical sealing.

Fig. 22 is an embodiment relating to an internally matched GaAs-FET: (a) is a plan view of a main part, while (b) is a front view of the same. The portions the same as those in Fig. 18 and Fig. 21 are given the same reference symbols.

In this embodiment, a GaAs-FET chip 105 is placed on the metal base 101 and in the centre of the inside of the case 102, and an insulator substrate 106 mounting a simple matching circuit is provided on both sides of said GaAs-FET chip 105, and these elements and internal strip lines are connected by lead bonding (not shown). The device has been used only in the frequency band below 10 [GHz] because of restriction from the viewpoint of package. But according to this embodiment, said package can be used in the entire frequency band of 20 [GHz] or lower, and moreover it can also be used up to the frequency band from 30 to 40 [GHz] through optimization of the structure.

Fig. 23 is a front view of the main portion of another embodiment. The portions the same as those in Fig. 22 are also given the same reference symbols.

This embodiment is different from that of Fig. 22 in that the metal base 101 and case 102 provide a cutaway part 107, and an electrical terminal 103 is engaged insertingly with the cut-away part, the electrical terminal having base 51 and bridge 53 with the upper surface of bridge 53 and the upper surface of case 102 set in the same plane, and a ceramic cover (not shown) with a metallized film or a metal cover, sealed thereon.

Fig. 24 is a front view of the main part of another embodiment and the portions the same as those in Fig. 23 are also given the same reference symbols.

This embodiment is different from that of Fig. 23 in that electric terminal 103 is engaged with cut-away part 107 by inserting it thereto, and a metal frame 108 is secured thereon. Thereby, the upper surface of bridge 53 is firmly earthed.

Fig. 25 is another embodiment: (a) is a plan view of the main part; (b) is a front view of the same. The portions the same as those in Fig. 22 are also given the same reference symbols.

In this embodiment, an ultra-miniature balanced amplifier (not shown) is placed on the sapphire substrate and it is then sealed into the case 102. Accordingly, this package is provided with a lead segment 109 which is used as a high frequency input terminal, lead segment 110 also used as an output terminal, lead segments 111 and 112 used as gate voltage output terminals and the lead segments 113 and 114 used as drain voltage terminals. If the gate voltage terminal and drain voltage terminal are used as DC input terminals, the other gate voltage terminal and drain voltage terminal are used as the output terminals for supplying DC voltages to a next stage. When a plurality of structures in accordance with this embodiment are connected, it is recommended to remove at least lead segments other than the first and the last ones and to mutually connect the strip lines by the lead-bonding method.

Devices of the prior art allow occurrence of high frequency coupling between the high frequency input/output terminals and DC terminals which can have an effect on signal output such as causing a dip due to resonance. However, this embodiment does not allow occurrence of such high frequency coupling because an electric terminal is isolated from DC terminal by the earth electrode (metal base) since it is formed as a pseudo-coaxial line and the strip line is also isolated from DC terminal by the earth electrode.

Fig. 26 is a diagram indicating the relationship between gain and frequency of the device which is explained in regard to Fig. 25 and designed and manufactured so that it can be operated in the frequency range from 8 to 18 [GHz]. Gain is plotted on the vertical axis, while frequency is plotted on the horizontal axis. A flat characteristic of 5 to 6 [dB] can be obtained in the frequency range from 8 to 18 [GHz]. Such an excellent high frequency characteristic has never been attained for a device sealed within a miniature package.

Fig. 27 illustrates relationship between input/output VSWR and frequency of a device explained in regard to Fig. 25. Input/output VSWR is plotted on the vertical axis and frequency on the horizontal axis, respectively. "in" indicates input characteristic and "out", output characteristic, respectively. Such excellent characteristics are partly attributed to the fact that connections to internal or external circuits are established between the strip lines.

Fig. 28 is an embodiment of a semiconductor device for high speed digital circuit: (a) is a plan view of a principal part and (b) is a front view of the same.

This embodiment is basically the same as that of Fig. 25, except only for the appearance.

In this Figure, 201 is a metal base; 202 is a case; 203 is an electric terminal; 204 is a semiconductor chip, respectively.

This embodiment is effective as a high speed A/D converter, high speed prescaler and high speed operation circuit and these circuits operate, for example, at the frequency up to several GHz in the case of a GaAs device. Currently, a device explained in regard to Fig. 2 is used and still suffers a disadvantage as explained previously. The sealing part between the metal base 201 and electric terminal 203 in this embodiment is designed as the pseudo-coaxial line and the characteristic impedance of the line including the strip line is 50 [Ω]. Namely, disadvantages of existing devices are perfectly eliminated. It is also possible not only for this embodiment but also for other embodiments to set the impedance of the entire part of the strip line - sealing part (pseudo-coaxial line part) - strip line to 50 [Ω] and for this purpose the strip line or its laminate part may sometimes take the shape of a tapered line rather than a straight line. Moreover, in the embodiment of Fig. 27, it is also possible to bond the lead segment to the strip line and extend it outside the metal base 201.

The device of Fig. 28 also allows installation of a GaAs differential amplifier. Fig. 29 is a diagram indicating relation between power gain and frequency. In this case, an excellent characteristic is also obtained.

A semiconductor device of the present invention provides a structure in which a strip line is formed on an insulator base, and the electric terminal providing an insulator bridge on an area in the vicinity of a laminate part of such a strip line is engaged with a through-passage by inserting it into a hole or cut-away part of a metal base having a metal case. Therefore, the electric terminal is directly secured over a wider area to the metal base which is kept at earth potential.

**Claims**

1. A semiconductor device, comprising:-
a metal case (102) with a through hole in its wall part, and a metal base (101);
a laminated electrical terminal (103) located in the through hole;
the laminated electrical terminal (103) comprising:-
an insulator base part (51) having a planar surface;
a strip line conductor layer (52) formed on the planar surface of the insulator base part; and
an insulator bridge part (53) abutting the planar surface of the insulator base part (52), and the strip line conductor layer (52) thereon, portions of the planar surface of the insulator base part (51), and the strip line conductor layer (52), being exposed on both sides of the insulator bridge part (53), the exposed portions extending to the inside and to the outside of the metal case (102).

2. A package as claimed in claim 1, wherein the insulator base part (51) and the insulator bridge part (53) are composed of ceramic material.

**Patentansprüche**

1. Halbleitervorrichtung mit:-
einem Metallgehäuse (102) mit einem Durchgangsloch in seinem Wandteil und einer Metallbasis (101);
einem laminierten elektrischen Anschluß (103), der in dem Durchgangsloch angeordnet ist;

welcher laminierte elektrische Anschluß (103) umfaßt:-
einen Isolatorbasisteil (51), der eine ebene Oberfläche hat;
eine Streifenleitungsschicht (52), die auf der ebenen Oberfläche des Isolatorbasisteils gebildet ist; und
einen Isolatorbrückenteil (53), der an der ebenen Oberfläche des Isolatorbasisteils (52) und der Streifenleiterschicht (52) darauf anliegt, wobei Abschnitte der ebenen Oberfläche des Isolatorbasisteils (51) und der Streifenleiterschicht (52) auf beiden Seiten des Isolatorbrückenteils (53) exponiert sind, und die exponierten Abschnitte sich zu der Innenseite und der Außenseite des Metallgehäuses (102) erstrecken.

2. Packung nach Anspruch 1, bei der der Isolatorbasisteil (51) und der Isolatorbrückenteil (53) aus keramischem Material zusammengesetzt sind.

**Revendications**

1. Dispositif à semi-conducteurs comprenant:
une boîte métallique (102) dotée d'un trou passant dans sa partie paroi et une base métallique (101);
une borne électrique stratifiée (103) qui est disposée dans le trou passant;
la borne électrique stratifiée (103) comprenant:
une partie base isolante (51) possédant une surface plane;
une couche conductrice de ligne plate symétrique (52) formée sur la surface plane de la partie base isolante; et
une partie pont isolante (53) disposée en appui contre la surface plane de la partie base isolante (52) et la couche conductrice de ligne plate conductrice (52) formée sur celle-ci, des parties de la surface plane de la partie base isolante (51) et la couche conductrice de ligne plate symétrique (52) étant exposées des deux côtés de la partie pont isolante (53), les parties exposées s'étendant jusqu'à l'intérieur et jusqu'à l'extérieur de la boîte métallique (102).

2. Boîtier selon la revendication 1, où la partie base isolante (51) et la partie pont isolante (53) sont constituées d'une matière céramique.

Fig. 1

Fig.2

Fig.3

Fig. 4

Fig. 5

Fig. 6

Fig. 7

Fig. 8

Fig. 9

Fig. 10

# Fig. 11

# Fig. 12

# Fig.13

# Fig.16

# Fig.14

# Fig.17

# Fig.15

# Fig.18

## Fig. 19

Loss

(dB)

0.2

0.1

2    10    20    (GHz)

Frequency

## Fig. 20

Reflection
Coefficient

0.1

0.05

2    10    20    (GHz)

Frequency

## Fig. 21

53    102    53
52                    52
51                    51
101

# Fig.22
## (a)

102   51   104   101

105   106
106

51   104

## (b)

104   53   103
102   101
51

# Fig.23

107   104   53
102   101
51
103

# Fig.24

107   104   53   108
102   101
51
103

# Fig.25

## (a)

## (b)

# Fig.26

Power Gain (dB) vs Frequency (GHz)

## Fig. 27

Input/Output
VSWR

Frequency

## Fig.28

(b)        (a)

202    202

204

203    201

## Fig.29

Voltage Gain

$10^4$  $10^5$  $10^6$  $10^7$  $10^8$  $10^9$  $10^{10}$

( Hz )

Frequency